# FASCICULE DE BREVET EUROPEEN

(11) **EP 2 388 806 B1**
(45) Date de publication et mention de la délivrance du brevet: **19.12.2018**
(21) Numéro de dépôt: 11354017.3
(22) Date de dépôt: 05.05.2011
(51) Int. Cl.: H01L 21/56, H01L 23/31, H01L 23/48, H01L 33/48, H01L 33/62

(54) **Procédé de réalisation d'éléments à puce semi-conductrice munis de rainures longitudunales d'insertion de fils**
Herstellungverfahren von Halbleiterchip-Elementen mit Aussparungen in Längsrichtung zum Einsetzen von Drähten
Fabrication process of semiconductor chip devices with longitudinal wire insertion notches

(30) Priorité: 18.05.2010 FR 1002080
(43) Date de publication de la demande: 23.11.2011
(73) Titulaire: COMMISSARIAT À L'ÉNERGIE ATOMIQUE ET AUX ÉNERGIES ALTERNATIVES, 75015 Paris (FR)
(72) Inventeur: Brun Jean, 38800 Champagnier (FR); Vicard Dominique, 38330 Saint-Nazaire-les-Eymes (FR)
(74) Mandataire: Talbot, Alexandre

(56) Documents cités:
- EP-A1- 0 360 660
- EP-A1- 2 099 060
- WO-A1-2009/112644
- FR-A1- 2 937 464
- US-A1- 2003 162 324
- US-A1- 2005 223 552
- US-A1- 2007 178 666

## Description

### Domaine technique de l'invention

L'invention est relative à des éléments à puce microélectronique, dont la plus grande dimension peut être inférieure au millimètre, que l'on solidarise à des fils conducteurs servant, par exemple, à alimenter les puces.

### État de la technique

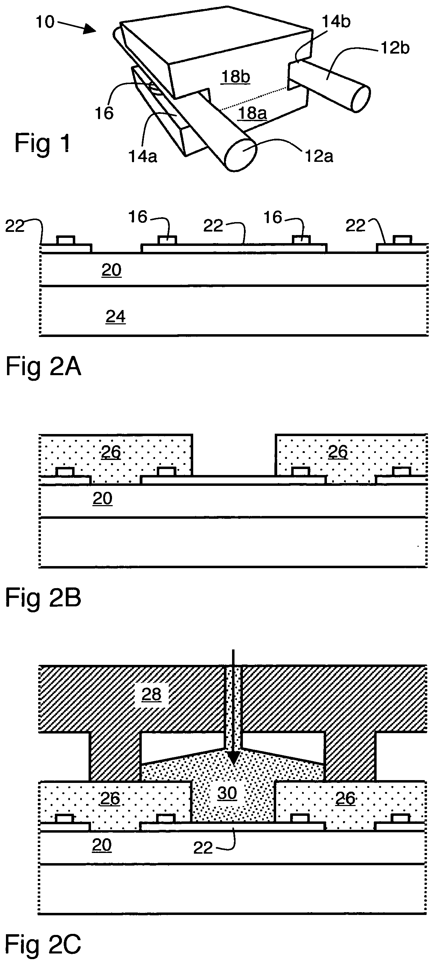

La figure 1 représente une vue en perspective d'un élément à puce 10 solidarisé à deux fils parallèles 12a et 12b, tel que décrit dans la demande de brevet WO2009112644. L'élément 10 est de forme générale parallélépipédique et deux de ses faces latérales opposées sont munies de rainures respectives parallèles 14a et 14b, qui s'étendant sur toute la longueur de l'élément 10. Chacune de ces rainures reçoit l'un respectif des fils 12a et 12b.

Les fils 12a et 12b ont généralement un rôle de connexion électrique, par exemple pour alimenter en courant électrique une diode électroluminescente formée dans la puce de l'élément 10. Ainsi, les fils 12a et 12b sont conducteurs et ils sont en connexion électrique avec la puce grâce à un plot conducteur 16 formé sur une paroi latérale de chaque rainure. La largeur des rainures et la hauteur des plots 16 sont sélectionnées en fonction du diamètre des fils 12, de manière que chaque fil soit pincé entre le plot et la paroi latérale opposée de la rainure 14.

Un élément du type de la figure 1 est généralement réalisé en deux parties. Une première partie 18a, correspondant au tiers inférieur de l'élément, est constituée de la puce. Une deuxième partie 18b, correspondant à la partie supérieure restante de l'élément, forme un capot protecteur. La face active de la puce, tournée vers le capot 18b, comporte les plots 16 et forme une première paroi latérale des rainures 14. Le capot 18b a une section en « T » lui permettant de former la deuxième paroi latérale et le fond des rainures.

Etant donné la petitesse des éléments à puce 10, l'assemblage des capots 18b sur les puces 18a pose un certain nombre de problèmes. Il est notamment difficile de respecter de manière reproductible l'écart entre les parois latérales des rainures 14. Comme le décrit la demande de brevet WO2009112644 susmentionnée, on peut souhaiter que les fils 12 soient maintenus par pincement élastique dans les rainures entre les plots 16 d'un côté, et les parois latérales opposées des rainures, de l'autre côté. Si l'écart est trop important, on ne parvient pas à pincer les fils 12. Si l'écart est trop faible, on ne parvient pas à insérer les fils dans les rainures sans casser l'élément 10.

### Résumé de l'invention

On cherche donc des moyens permettant d'assurer un écart reproductible et précis entre les parois latérales des rainures.

Pour tendre à satisfaire ce besoin, on prévoit un procédé de réalisation selon les revendications annexées.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente une vue en perspective d'un élément à puce solidarisé à deux fils ;
- les figures 2A à 2F représentent diverses étapes d'un procédé permettant de réaliser des éléments à puce avec des rainures de largeur précise et reproductible.

### Description d'un mode de réalisation préféré de l'invention

La figure 2A représente une vue en coupe partielle d'une plaquette 20 sur laquelle on a formé un ensemble de dispositifs intégrés 22 correspondant aux puces 18a des éléments à puce que l'on souhaite réaliser. Chacun de ces dispositifs 22 est muni, sur deux de ses bords, des plots conducteurs 16 servant ultérieurement à établir le contact avec les fils 12.

La plaquette 20, par exemple en silicium, a dans cet exemple été amincie pour que son épaisseur soit compatible avec les dimensions souhaitées des éléments à puce finaux. De préférence, du fait que la plaquette 20 a été amincie et présente une rigidité réduite, on l'a solidarisée par sa face arrière à une plaque support, ou « poignée » 24, offrant à l'ensemble la rigidité requise pour les diverses étapes du procédé de réalisation. L'assemblage de la plaquette 20 sur la plaque support 24 doit en règle générale résister aux températures élevées rencontrées lors de diverses opérations de fabrication des dispositifs 22.

A la figure 2B on dépose un film sacrificiel 26 en couche épaisse, par exemple 100 *µ*m, sur la face supérieure de la plaquette 20. Ce film 26 est en un matériau apte à être structuré, planarisé, et éliminé par des techniques usuelles dans le domaine des semi-conducteurs. Il s'agit, par exemple, d'une résine, d'un polyimide, ou d'un métal.

L'épaisseur de ce film 26 définit, comme on le verra ci-après, la largeur des futures rainures 14. Les techniques de dépôt usuelles permettent d'obtenir une précision amplement suffisante de l'épaisseur du film. La distance que l'on souhaite précise est en fait celle séparant le sommet de chaque plot 16 de la paroi opposée de la rainure. Les techniques de réalisation des plots 16 permettent également d'obtenir la précision requise.

Comme cela est représenté, le film 26 est structuré, par exemple par photolithographie, pour laisser exposées les parties centrales des dispositifs 22, tout en recouvrant les bords munis des plots 16 (les zones destinées à former les premières parois latérales des futures rainures). La structuration est de préférence anisotrope afin que les ouvertures dans le film 26 présentent des parois perpendiculaires à la plaquette, ces parois servant à définir les fonds des futures rainures.

A la figure 2C on applique sur le film 26 un moule 28 comportant des cavités en correspondance avec les dispositifs 22. Les cavités du moule 28, ensemble avec les orifices dans le film 26, définissent la forme des futurs capots 18b des éléments à puce, par exemple des capots avec une section en « T ».

Dans chaque cavité du moule 28, on injecte un matériau liquide durcissable 30, présentant les propriétés souhaitées pour les capots, par exemple une résine époxy transparente dans le cas où les dispositifs 22 sont des diodes électroluminescentes.

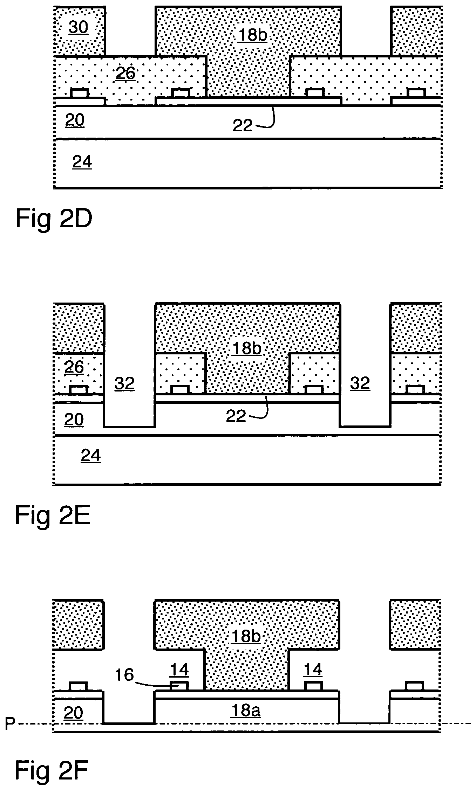

La figure 2D représente le résultat obtenu après durcissement de la résine 30 et enlèvement du moule 28. La résine 30, en relief au-dessus des dispositifs 22, forme les capots 18b et laisse exposé le film 26 dans des zones entourant les dispositifs 22.

A la figure 2E, on procède à un sciage par la face supérieure pour séparer les dispositifs 22 et former les puces 18a. Comme cela est représenté, les traits de scie 32 passent dans les espaces laissés par le moule entre les capots 18b, traversent le film 26, et entament la plaquette 20 sans la traverser.

A la figure 2F, les restes du film sacrificiel 26 sont éliminés, par exemple par gravure plasma ou chimique. On dégage ainsi les rainures 14 définies par les capots 18b au dessus des plots 16 des puces 18a.

L'élimination du film sacrificiel 26 a de préférence lieu après le sciage. En procédant dans cet ordre, on évite que des copeaux de sciage se déposent dans les rainures 14 et nuisent à l'établissement du contact électrique ultérieur entre les fils 12 et les plots 16.

On procède ensuite à l'enlèvement de la plaque support 24, puis au meulage de la plaquette 20 en face arrière jusqu'à un plan P au niveau des fonds des traits de scie, pour obtenir les éléments à puce 10 individuels.

Afin de maintenir la plaquette 20 pendant l'enlèvement de la plaque 24 et le meulage, on peut, par exemple, plaquer les capots 18b sur un support adhésif décollable, non représenté. Après le meulage, les éléments à puce individuels 10 restent collés au support adhésif et ils se trouvent alors dans un conditionnement semblable à celui de puces classiques après sciage d'une plaquette. Les éléments à puce peuvent ensuite être exploités par des outils classiques de manipulation de puces.

Selon une variante, la plaque support 24 est retirée avant l'étape de sciage de la figure 2E, et la plaquette 20 est solidarisée par sa face arrière à un support adhésif décollable. Alors, les traits de scie 32 traversent la plaquette 20 et entament le support adhésif.

Pour terminer la réalisation des éléments à puce, il ne reste plus qu'à éliminer les restes de film sacrificiel 26 se trouvant au niveau des rainures 14. Cette élimination est de préférence faite par un procédé à basse température compatible avec l'adhésif, par exemple en prévoyant le film sacrificiel 26 en un métal que l'on peut éliminer par gravure chimique.

On se retrouve alors, comme dans le cas précédent, avec un ensemble d'éléments à puce individuels 10 collés sur un support, prêts à être exploités par des outils de manipulation classiques. Dans cette variante, au lieu d'être collés à un support par les capots 18b, les éléments sont collés par les puces 18a.

Un avantage de cette variante est qu'elle évite l'étape de meulage de la face arrière de la plaquette 20 et un risque que des copeaux dus au meulage ne viennent se déposer dans les rainures 14.

Selon une autre variante, le moule illustré à la figure 2C ne comporte pas une cavité individualisée pour chaque dispositif 22, mais une cavité unique s'étendant sur l'ensemble des dispositifs 22. Dans ce cas, après injection et durcissement de la résine 30, on se retrouve à l'étape de la figure 2D avec une couche de résine 30 recouvrant uniformément le film sacrificiel 26. Les capots individuels 18b sont alors formés à l'étape de la figure 2E par les traits de scie 32.

## Revendications

1. Procédé de réalisation d'éléments à puce microélectronique (10) munis chacun d'au moins une rainure (14) à partir de dispositifs (22) formés sur une plaquette (20), le procédé comprenant les étapes suivantes :
• déposer sur la plaquette (20) un film sacrificiel (26) de manière à laisser exposée une partie centrale de chaque dispositif (22) et à recouvrir, pour chaque dispositif, au moins un bord du dispositif muni d'un plot conducteur (16) au niveau duquel on souhaite former la rainure ;
• appliquer un moule (28) sur le film sacrificiel (26) ;
• injecter une matière durcissable (30) dans le moule (28) de façon à recouvrir de matière durcissable (30), pour chaque dispositif, la partie centrale exposée ainsi que la portion du film sacrificiel (26) recouvrant ledit au moins un bord du dispositif muni d'un plot conducteur (16) ;
• durcir la matière durcissable (30) ;
• scier la plaquette entre les dispositifs ; et
• éliminer le film sacrificiel (26) de sorte à former, pour chaque élément à puce microélectronique (10), la au moins une rainure (14) dont une paroi latérale et le fond sont formés par la matière durcissable à l'état durci.

2. Procédé selon la revendication 1, dans lequel le moule (28) comprend une cavité associée à chaque puce.

3. Procédé selon la revendication 1, dans lequel l'étape de sciage a lieu avant l'étape d'élimination du film sacrificiel.

4. Procédé selon la revendication 1, dans lequel les traits de scie (32) formés à l'étape de sciage ne traversent pas intégralement la plaquette (20), le procédé comprenant en outre une étape consistant à meuler la plaquette en face arrière jusqu'à atteindre les traits de scie.

5. Procédé selon la revendication 1, dans lequel la plaquette (20) est fixée par sa face arrière à une plaque support (24), le procédé comprenant une étape consistant à retirer la plaquette de la plaque support après l'étape de sciage.

## Patentansprüche

1. Verfahren zur Herstellung von Mikroelektronik-Chipelementen (10), die jeweils mit mindestens einer Rille (14) versehen sind, aus Vorrichtungen (22), die auf einem Plättchen (20) gebildet sind, wobei das Verfahren die folgenden Verfahrensschritte umfasst:
- auf dem Plättchen (20) wird ein Opferfilm (26) dergestalt aufgetragen, dass ein mittlerer Bereich jeder Vorrichtung (22) frei gelassen wird und bei jeder Vorrichtung mindestens ein Rand der Vorrichtung, der mit einem leitenden Kontaktklotz versehen ist, in dessen Bereich die Rille gebildet werden soll, bedeckt wird;
- es wird eine Spritzform (28) auf dem Opferfilm (26) angebracht;
- es wird ein härtbarer Werkstoff (30) in die Spritzform (28) eingespritzt, so dass bei jeder Vorrichtung der frei gelassene mittlere Bereich sowie der Bereich des Opferfilms (26), der den genannten mindestens einen Rand der Vorrichtung, der mit einem leitenden Kontaktklotz versehen ist, bedeckt, mit härtbarem Werkstoff (30) bedeckt wird;
- der härtbare Werkstoff (30) wird gehärtet;
- das Plättchen wird zwischen den Vorrichtungen durchgesägt; und
- der Opferfilm (26) wird entfernt, so dass bei jedem Mikroelektronik-Chipelement (10) die mindestens eine Rille (14) entsteht, deren eine Seitenwand und deren Boden von dem härtbaren Werkstoff in gehärtetem Zustand gebildet werden.

2. Verfahren nach Anspruch 1, wobei die Spritzform (28) einen Hohlraum enthält, der jedem Chip zugeordnet ist.

3. Verfahren nach Anspruch 1, wobei der Verfahrensschritt des Sägens vor dem Verfahrensschritt des Entfernens des Opferfilms erfolgt.

4. Verfahren nach Anspruch 1, wobei die beim Verfahrensschritt des Sägens hergestellten Sägenschnitte (32) das Plättchen (20) nicht vollständig durchqueren, wobei das Verfahren ferner einen Verfahrensschritt enthält, der darin besteht, das Plättchen an der Rückseite abzuschleifen, bis die Sägenschnitte erreicht sind.

5. Verfahren nach Anspruch 1, wobei das Plättchen (20) mit seiner Rückseite an einer Trägerplatte (24) befestigt wird, wobei das Verfahren einen Verfahrensschritt enthält, der darin besteht, das Plättchen nach dem Verfahrensschritt des Sägens von der Trägerplatte zu lösen.

## Claims

1. A method for fabricating microelectronic chip elements (10) each provided with a groove (14) from devices (22) formed on a wafer (20), the method comprising the following steps:
• depositing a sacrificial film (26) on the wafer (20) so as to leave a central part of each device (22) exposed and, for each device, to cover at least one edge of the device provided with a conductive pad (16) at the level of which the groove is to be formed;
• applying a mold (28) on the sacrificial film (26);
• injecting a hardenable material (30) into the mold (26) so as to cover for each device (22) the exposed central part and the portion of the sacrificial film (26) covering said at least one edge of the device provided with a conductive pad (16) by means of hardenable material (30) ;
• hardening the hardenable material;
• dicing the wafer between the devices; and
• eliminating the sacrificial film (26) so as to form, for each microelectronic chip elements (10), the at least one groove a sidewall and the bottom of which are formed by the hardenable material in hardened state.

2. The method according to claim 1, wherein the mold (28) comprises a cavity associated with each chip.

3. The method according to claim 1, wherein the dicing step takes place before the sacrificial film elimination step.

4. The method according to claim 1, wherein the dicing cuts (32) formed in the dicing step do not pass completely through the wafer (20), the method further comprising a step consisting in grinding the wafer on the rear surface thereof until the dicing cuts are reached.

5. The method according to claim 1, wherein the wafer (20) is fixed via its rear surface to a support plate (24), the method comprising a step consisting in removing the wafer from the support plate after the dicing step.
